# EUROPEAN PATENT SPECIFICATION

(11) **EP 0 672 259 B1**
(45) Date of publication and mention of the grant of the patent: **17.10.2001**
(21) Application number: 94926361.0
(22) Date of filing: 23.09.1994
(51) Int. Cl.: G01R 33/06, G11B 5/02, G11B 5/39

(54) **ARRANGEMENT FOR READING INFORMATION FROM A TRACK ON A RECORD CARRIER**
VORRICHTUNG ZUM AUSLESEN VON INFORMATIONEN VON EINER SPUR EINES AUFZEICHNUNGSTRÄGERS
DISPOSITIF DE LECTURE D'INFORMATIONS A PARTIR D'UNE PISTE D'UN DISQUE MAGNETIQUE

(30) Priority: 23.06.1994 EP 94201804; 06.10.1993 EP 93202836
(43) Date of publication of application: 20.09.1995
(73) Proprietor: Koninklijke Philips Electronics N.V., 5621 BA Eindhoven (NL); PHILIPS NORDEN AB, 164 85 Stockholm (SE)
(72) Inventor: VOORMAN, Johannes, Otto, NL-5621 BA Eindhoven (NL); VILA LOBOS RAMALHO, Joao, Nuno, NL-5621 BA Eindhoven (NL)
(74) Representative: Hesselmann, Gerardus Johannes Maria
(86) International application number: IB9400291
(87) International publication number: WO9510049

(56) References cited:
- EP-A- 0 241 770
- US-A- 5 122 915
- US-A- 5 204 789
- US-A- 5 270 882

## Description

The invention relates to an arrangement for reading out an information signal from a magnetic record carrier, comprising
- a read head having a first magneto-resistive element with a first terminal connected to a first point of constant potential, and with a second terminal,
- a first bias-current means for supplying a bias-current,
- a first amplifier circuit comprising an output terminal for supplying the information signal, a first terminal coupled to the first bias-current means and to the output terminal, a second terminal coupled to the second terminal of the first magneto-resisitive element so as to form a series arrangement of the first bias-current means, the first amplifier circuit and the magneto-resistive element between a second point of constant potential and said first point of constant potential, the first amplifier circuit further comprising a first transistor, a first feedback circuit, a first load impedance and a first capacitor element, a first main flow terminal of the first transistor being connected to the second terminal of the first amplifier circuit, a second main flow terminal of the first transistor being coupled to the first terminal of the first amplifier circuit, a control terminal of the first transistor being coupled to the output terminal of the first amplifier circuit via the first feedback circuit, the first load impedance being coupled between the output terminal of the first amplifier circuit and a reference voltage terminal.

Such an arrangement is known from the document US-A-5 122 915. In this known arrangement current biasing and current sensing of the magneto-resistive element is combined, thereby providing a low-noise amplification.

It is an object of the invention to improve the noise behaviour of the known arrangement. In accordance with an aspect of the invention, the known arrangement is characterized in that the arrangement further comprises
- a second bias-current means for supplying a bias-current,
- a second amplifier circuit comprising an output terminal, a first terminal coupled to the second bias-current means and to the output terminal, a second terminal for coupling to a second terminal of a second magneto-resistive element of the read head for reading out the same information signal from the magnetic record carrier as the first magneto-resistive element so as to form a series arrangement of the second bias-current means, the second amplifier circuit and the second magneto-resistive element between the second point of constant potential and said first point of constant potential, the second amplifier circuit further comprising a second transistor, a second feedback circuit, a second load impedance and a second capacitor element, a first main flow terminal of the second transistor being connected to the second terminal of the second amplifier circuit, a second main flow terminal of the second transistor being coupled to the first terminal of the second amplifier circuit, a control terminal of the second transistor being coupled to the output terminal of the second amplifier circuit via the second feedback circuit, the second load impedance being coupled between the output terminal of the second amplifier circuit and a reference voltage terminal,
and in that
the control terminal of the second transistor is coupled to the second terminal of the first amplifier circuit via the second capacitor element, and the control terminal of the first transistor is coupled to the second terminal of the second amplifier circuit via the first capacitor element.

The arrangement according to the invention provides a balanced version of the known arrangement wherein the first and second capacitor elements are cross-coupled to the second terminals of the individual amplifiers instead of to ground. The cross-coupling causes a shunting of the noise resistances of the first and second transistors and effects a reduced noise contribution of the first and second transistors.

A further noise reduction is obtained in an arrangement which is characterized in that the first terminal of the first amplifier circuit is coupled to the output terminal of the first amplifier circuit via a cascode transistor having an first main flow terminal connected to the first terminal of the first amplifier circuit and a second main flow terminal coupled to the output terminal of the first amplifier circuit and in that the first terminal of the second amplifier circuit is coupled to the output terminal of the second amplifier circuit via a cascode transistor having an first main flow terminal connected to the first terminal of the second amplifier circuit and a second main flow terminal coupled to the output terminal of the second amplifier circuit.

In order to obtain low noise, the first and second transistors should be large. By cascoding these large transistors the following advantages are obtained. The large first and second transistors and the first and second bias current generators can have a low output impedance, since they feed their respective currents into a very low-ohmic emitter of the cascode transistor. The drain-to-gate capacitance of the large first and second transistors is not Millered. The first and second bias current generators provide lower bias current and a corresponding lower noise because part of the total bias current for the magneto-resistive element is provided by the parallel arranged cascode transistor. The bias current generators feed current to a low voltage node, so that a maximum voltage range is available for the bias-current source, so as to enable the bias-current generator to be optimal for low noise, for example by using a current source transistor with a large emitter degeneration resistor.

The above and other features and advantages of the invention will be apparent from the following description of exemplary embodiments of the invention with reference to the accompanying drawings, in which:
Figure 1 shows a known arrangement for reading information from a track on a record carrier,
Figures 2A, 2B, 2C show versions of a feedback circuit for use in the arrangement of Figure 1,
Figures 3A, 3B, 4A, 4B and 5 show versions of an amplifier circuit for use in the arrangement of Figure 1,
Figure 6 shows a balanced arrangement according to the invention,
Figure 7 shows an arrangement having shielding means provided over the electrical connection between the MR element and the amplifier circuit,
Figure 8 shows the reading of information from a track on a disk shaped record carrier,
Figure 9A and 9B show circuit parts that can be coupled together so as to realize a multiplexed read out by means of two or more separate MR elements,
Figure 10 shows the circuit part for realizing a multiplexed read out by means of two or more separate heads, each head having two MR elements,
Figure 11 shows an amplifier for use in the balanced arrangement according to the invention, and
Figure 12 shows an embodiment of a balanced arrangement according to the invention.

Like reference symbols are employed in the drawings and in the description of the preferred embodiments to represent the same or very similar item or items.

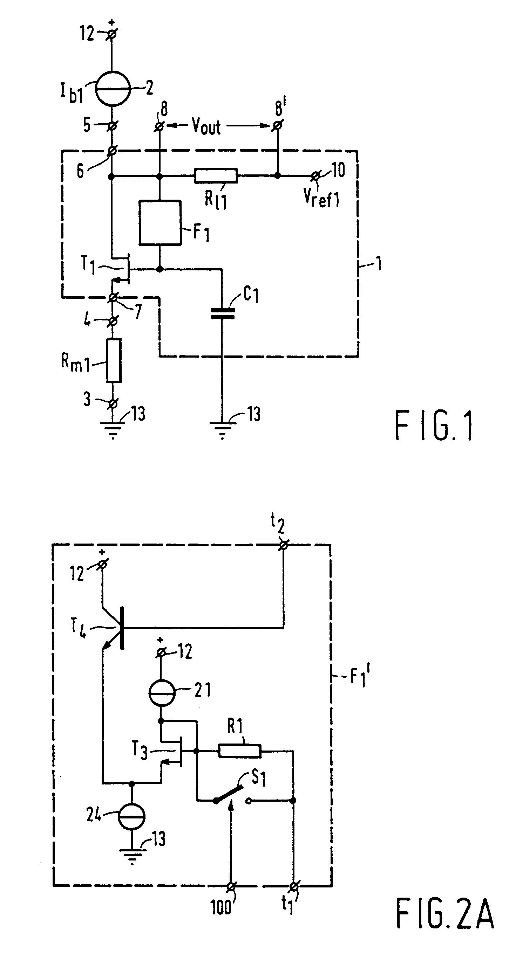

Figure 1 shows the basic circuit construction of the arrangement known from the document US-A-5 122 915 which comprises a read head (not shown) having a magneto-resistive (MR) element Rₘ₁, a bias-current generator 2 for generating a bias-current I_{b1}, and an amplifier circuit 1. A first terminal 3 of the magneto-resistive element Rₘ₁ is connected to a first point of constant potential 13, which is ground potential. An output 5 of the bias-current generator 2 is coupled to a first terminal 6 of the amplifier circuit 1. A second terminal of the bias-current generator 2 is coupled to a point of constant potential 12 (the positive supply voltage, denoted by +). A second terminal 7 of the amplifier circuit 1 is coupled to a second terminal 4 of the magneto-resistive element Rₘ₁. An output terminal 8,8' is available for supplying the information signal read out.

The amplifier circuit 1 comprises a transistor T₁, a feedback circuit F₁ and a capacitor element C₁. The transistor T₁ is in the form of a MOSFET or a jFET. Its source terminal is coupled to the second terminal 7 of the amplifier circuit 1. Its drain terminal is coupled to the first terminal 6 of the amplifier circuit 1. Its gate terminal is coupled to the first point of constant potential 13, via the capacitor element C₁. Further, the feedback circuit F₁ is coupled between the gate of the transistor T₁ and the terminal 6 of the amplifier circuit 1. The drain terminal of the transistor T₁ is further coupled to a reference point 10 via a load impedance R₁. At the reference point 10 a voltage V_{ref} is available, which needs not be a constant potential, but may vary, as will be explained later. At output terminal 8,8' the voltage occurring over the load impedance R₁ is present. The bias-current generator 2, the amplifier circuit 1, more specifically the transistor T₁ in the amplifier circuit 1, and the MR element Rₘ₁ form a series arrangement between the terminals 3 and 12.

As can be seen from the figure, the MR element Rₘ₁ is connected to ground via its terminal 3. Further, when used in an arrangement for reading an information signal from a disk shaped record carrier (not shown), the disk is also preferably electrically connected to ground. This limits the possibility that a voltage difference can be built up between the head and the disk. This avoids electrical discharges that could otherwise occur between head and disk, which discharges could damage the head.

The MR element Rₘ₁, the amplifier 1 and the bias-current generator 2 form a series arrangement between the two (supply) terminals 3 and 12. Thus, the current supplied by the bias-current generator 2 is fed to the MR element Rₘ₁ so as to bias the MR element Rₘ₁, as well as to the amplifier circuit 1. This bias current through the amplifier circuit results in a certain noise contribution, which is lower when the current through the amplifier circuit is higher. If the amplifier circuit would be in parallel to the MR element Rₘ₁ and the bias-current generator, a larger current would be needed to bias the MR element Rₘ₁ and to supply the input stage of the amplifier circuit with the current needed to obtain a low noise contribution in the amplifier circuit. Thus the arrangement of Figure 1 produces less noise and requires less bias current, with is a major advantage in the case of battery powered supply voltages.

When the amplifier circuit has only one transistor, such as in the embodiment of Figure 1, instead of two in the case of a long-tailed pair, the amplifier circuit has a lower noise contribution.

Variations in the magnetic field detected by the MR element Rₘ₁ lead to variations in the resistance value of the MR element. The gate of transistor T₁ is coupled to ground for AC signals by means of the capacitor C₁. This means that for AC signals, the terminal 4 of the MR element Rₘ₁ lies virtually to ground. As a result of this, variations in the resistance value of the MR element can only lead to variations in the current through the series arrangement. These current variations are fed via the load impedance R₁₁ to the terminal 10, and lead to a voltage variation across the load impedance R₁₁. This voltage variation is detected at the terminals 8,8' as the output signal of the amplifier circuit.

The feedback circuit F₁ realizes a low cut-off frequency. In order to enable integration of the capacitor C₁, the resistance value of F₁ should be high. This results in the transistor T₁ acting like a diode for DC signals, so that the bias-current I_{b1} can be fed to the MR element Rₘ₁. The feedback circuit F₁ is an impedance network. In its most simple form, the feedback circuit can be a resistor.

In order to make the arrangement suitable for use at low supply voltages applied to the terminals 3 and 12, it is necessary to make the voltage drop between the terminals 4 and 6 as small as possible, so that a maximum voltage range is available for the bias-current source (2), so as to enable the bias-current source to be optimal for low noise.

Figure 2A shows a further-elaborated version of the feedback circuit F₁, so as to make it high ohmic and to realize a voltage drop across the transistor T₁ which is as small as possible. The feedback circuit F₁ comprises a transistor T₃, which is a MOS transistor, a bipolar transistor T₄ and a resistor R₁. Both transistors T₁ and T₃ are of the same type, MOSfet or jFET. The gate terminal of the transistor T₁ is coupled to the terminal t₁ of the feedback circuit. The terminal t₁ is coupled to the gate terminal of the third transistor T₃ via the resistor R₁. The source terminal of the third transistor T₃ is coupled to the emitter terminal of the fourth transistor T₄. The base terminal of the transistor T₄ is coupled to the terminal t₂ of the feedback circuit, which terminal is coupled to the terminal 6 of the amplifier circuit. The gate and drain terminal of the transistor T₃ are interconnected so as to form a diode. Further, the interconnected gate and drain terminals are coupled to the point 12 of constant potential via a current source 21. The emitter of the transistor T₄ is coupled to the first point of constant potential 13 via a current source 24. Further, the collector of the transistor T₄ is coupled to the second point of constant potential 12. The current sources provide current supply for the transistors T₃ and T₄.

By means of the feedback part of Figure 2A, a voltage shift of -Vₜₕ + V_{d} is obtained between the terminals t₁ and t₂, where Vₜₕ is the threshold voltage of a MOS transistor, such as the transistors T₁ and T₃, and V_{d} is the voltage across a bipolar diode. As a result, the voltage difference between the terminals 6 and 7 of the amplifier circuit of Figure 1, is roughly V_{d}, or substantially 0.7 V.

More specifically, the voltage difference between the terminals 6 and 7 is V_{d} + V_{ch1} - V_{ch2}, where V_{ch1} and V_{ch2} are the channel voltages of the transistors T₁ and T₃ respectively, which are dependent of the drain current through those transistors (V_{ch} = V_{gs} - Vₜₕ, where V_{gs} is the gate-source voltage and Vₜₕ the threshold voltage of a transistor).

Further, the impedance formed by the feedback circuit between the terminals t₁ and t₂ is high-ohmic so as to obtain the desired low value for the cut-off frequency of the lower band edge of the frequency characteristic of the amplifier circuit. The circuit of Figure 2A has current sources coupled to both the positive (12) as the negative (13) supply voltage terminal.

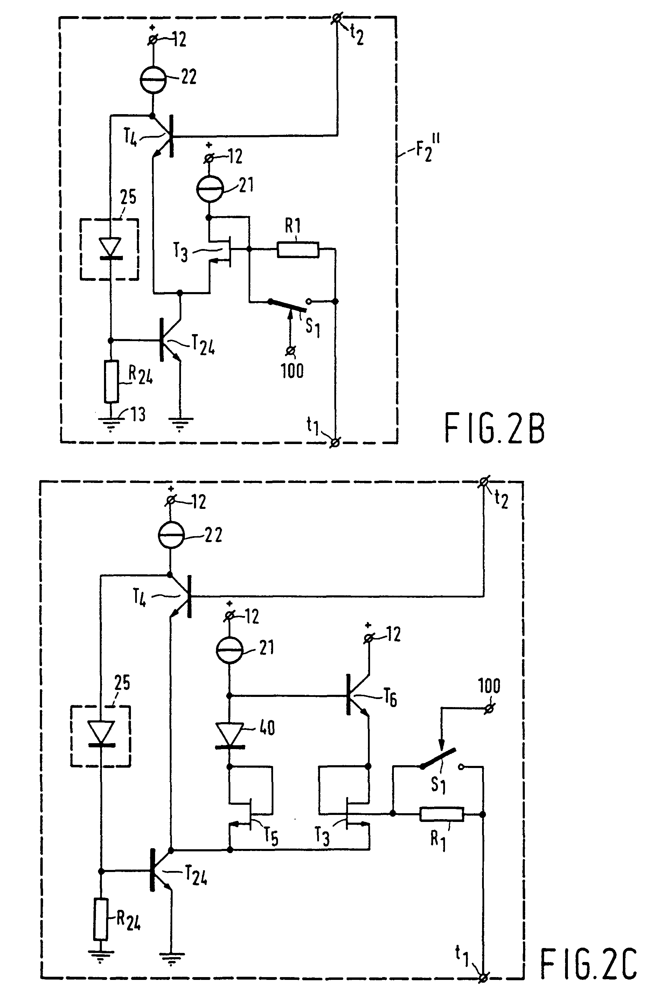

Figure 2B shows a further elaborated version of the feedback circuit of Figure 2A, which has current sources connected to the positive supply terminal only. The circuit of Figure 2B further comprises a diode arrangement 25 of one or more diodes, a bipolar transistor T₂₄, a current source 22 and a resistor R₂₄. The current source 22 is coupled between the point 12 of constant potential and the collector of the transistor T₄, and is further coupled via the diode arrangement 25 to the base terminal of the transistor T₂₄. The base terminal of the said transistor is also coupled to the point 13 of constant potential via the resistor R₂₄. The emitter of the transistor T₂₄ is coupled to the point 13 of constant potential, and its collector is coupled to the interconnected emitter and source of the transistors T₄ and T₃ respectively.

The circuit part formed by the elements 22, 25, R₂₄ and T₂₄ effectively replaces the current source 24 in Figure 2A.

The circuits of the Figures 2A and 2B further show a switch S₁ connected in parallel to the resistor R₁. When activating the amplifier circuit of Figure 1, or when the current value through the MR element should be changed, the capacitor C₁ must initially be charged (or discharged) so that the amplifier circuit can settle to the new situation. In order to settle fast, the resistor R₁ is short-circuited by the switch S₁ under the influence of a switching signal applied to the control signal input 100, so that the current for charging the capacitor C₁ can be supplied by the current source 21, or discharging can take place via the current source 24. The charging time of the capacitor C₁ is thus limited by the maximum current that can be supplied by the current source 21, and the discharging time is limited by the maximum current that can be received by the current source 24. Replacing the current source 24 of Figure 2A by the elements 22, 25, R₂₄ and T₂₄ in Figure 2B already offers a shortening of the discharge time, as the transistor T₂₄ can sink currents which are up to two orders of magnitude larger than the current through the current source 22.

Figure 2C shows a feedback circuit in which the charging time of the capacitor C₁ can be shortened. The circuit of Figure 2C further comprises a MOS transistor T₅, a bipolar transistor T₆ and a bipolar diode element 40. The gate and drain terminals of the transistor T₅ are interconnected and both coupled to the current source 21 and to a base terminal of the transistor T₆ via the diode element 40. The source terminals of the transistors T₃ and T₅ are interconnected. A collector terminal of the transistor T₆ is coupled to point 12 of constant potential. An emitter terminal of the transistor T₆ is coupled to the interconnected gate and drain terminals of the transistor T₃. The circuit comprising the transistors T₃, T₆ and T₅ and the diode element 40 form a class-A/B circuit and provides a quicker charging of the capacitor element C₁ during initialisation of the arrangement by means of current supplied by the transistor T₆.

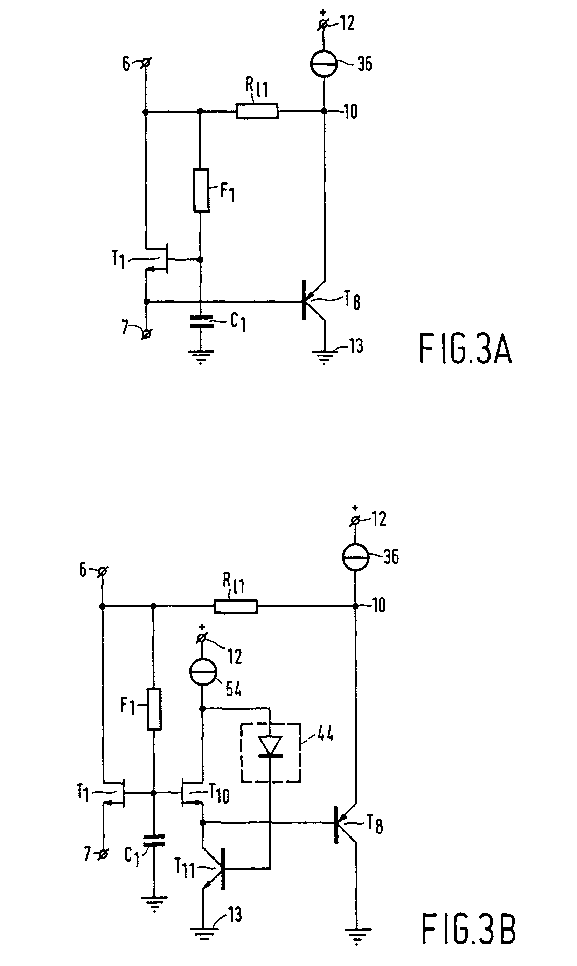

Figure 3A shows a further-elaborated version of the amplifier circuit 1 of Figure 1. The circuit of Figure 3A comprises a bipolar transistor T₈, which has its base terminal coupled to the source terminal of the transistor T₁, its collector to the point 13 of constant potential, and its emitter coupled to the reference point 10. Further a current source 36 is coupled between the reference point 10 and the second point 12 of constant potential. This circuit has the advantage that the DC voltage present at the reference point 10 follows the DC voltage present at the terminal 7 of the amplifier circuit. This means that voltage variations occurring across the MR element Rₘ₁ do not appear across the load resistor R₁₁.

The voltage difference between the terminals 7 and 10 is equal to V_{d}. If F₁ is one of the circuits of the Figures 2A, 2B or 2C, the voltage difference between the terminals 6 and 7 equals V_{d} + V_{ch1} - V_{ch2}, see above, so that the DC offset across the load resistor R₁₁ is low (V_{ch1} - V_{ch2}). Only voltage variations in the transistor T₁, resulting from the current variations through the transistor T₁, still appear across the load resistor R₁₁.

A further improvement of the amplifier circuit of Figure 3A is disclosed in Figure 3B. The amplifier circuit 1 further has a MOS transistor T₁₀ and a bipolar transistor T₁₁. The gate of transistor T₁₀ is connected to the gate of the transistor T₁, the drain is coupled to the point 12 of constant potential via a current source 54, as well as coupled to the base of the transistor T₁₁ via a diode arrangement 44 consisting of one or more series connected diodes. The source of the transistor T₁₀ is coupled to the collector of the transistor T₁₁ as well as to the base of the transistor T₈. The emitter of the transistor T₁₁ is coupled to the point 13 of constant potential.

The voltage difference between the gate of the transistor T₁ and the terminal 10 equals V_{gs} - V_{d}, where V_{gs} is the gate-source voltage of the transistor T₁₀. If F₁ is again one of the circuits of the Figures 2A, 2B or 2C, the voltage difference between the gate of the transistor T₁ and terminal 6 equals V_{gs}' - V_{d}, where V_{gs}' is the gate-source voltage of the transistor T₃. The voltage across the load resistor R₁₁ now equals V_{gs}' - V_{gs}. If the current through transistor T₁₀ is made equal to the current through the transistor T₃, and further the transistors T₁₀ and T₃ have equal dimensions, the said voltage becomes practically zero, independent of the value of the MR bias current.

It will be clear that, instead of the combination of the current source 54, the diode arrangement 44 and the transistor T₁₁, a current source could have been coupled between the emitter of the transistor T₁₁ and ground potential.

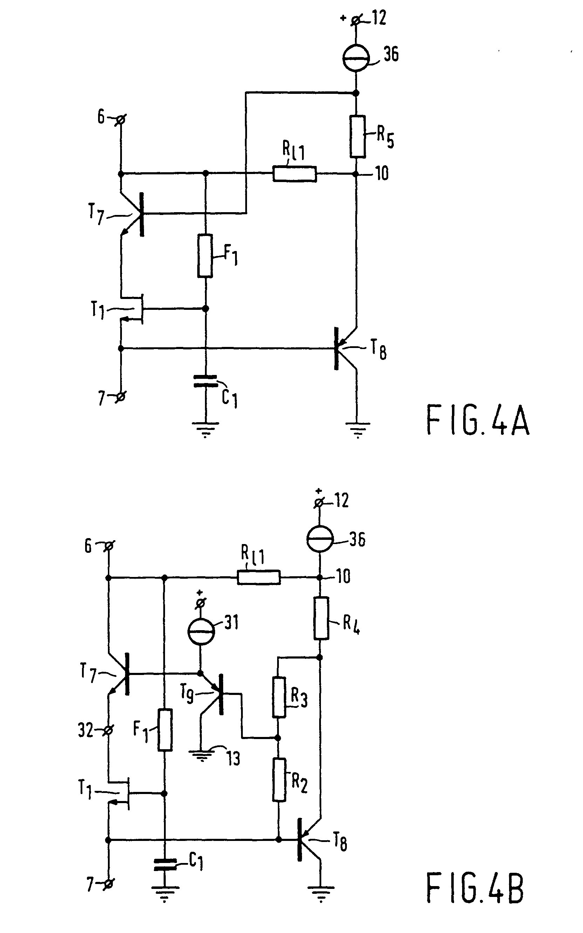

Figure 4A shows a further improvement of the amplifier circuit of Figure 3A. The amplifier circuit comprises a bipolar transistor T₇ which is coupled between the drain terminal of the transistor T₁ and the terminal 6. Its base terminal is coupled to the point 12 of constant potential via the current source 36, and to the point 10 via a resistor R₅.

By means of the transistor T₇, the transistor T₁ is cascoded in order to get a higher output impedance at the terminal 6 and to prevent the Millering of the drain-gate capacitance of transistor T₁.

Figure 4B shows an alternative of the amplifier circuit of Figure 4A. It additionally comprises a transistor T₉, resistors R₂, R₃ and R₄ and a current source 31. The base terminal of the transistor T₇ is connected to an emitter terminal of the transistor T₉, a base terminal of which is coupled to the source terminal of the transistor T₁ via the resistor R₂. The collector of the transistor T₉ is coupled to the point 13 of constant potential. The emitter of the transistor T₉ is further coupled to the point 12 of constant potential via the current source 31. The base of the transistor T₉ is coupled to the emitter of the transistor T₈ via the resistor R₃, and to the reference point 10 via the resistors R₃ and R₄.

Further, the construction of the transistors T₇ and T₉ provides a voltage at the interconnection node 32 of the emitter of transistor T₇ and the drain of transistor T₁, which is roughly half way between the voltages present on the terminals 7 and 6. This means that a voltage difference of V_{d}/2 is present between the node 32 and the terminal 7, and between the nodes 32 and the terminal 6, as the voltage difference between the terminals 6 and 7 is V_{d}, as explained previously.

It should be noted that Figure 4A and Figure 4B are derived from Figure 3A by adding the cascode transistor T₇, using different biasing schemes. The same cascode principles can be added to the circuit of Figure 3B.

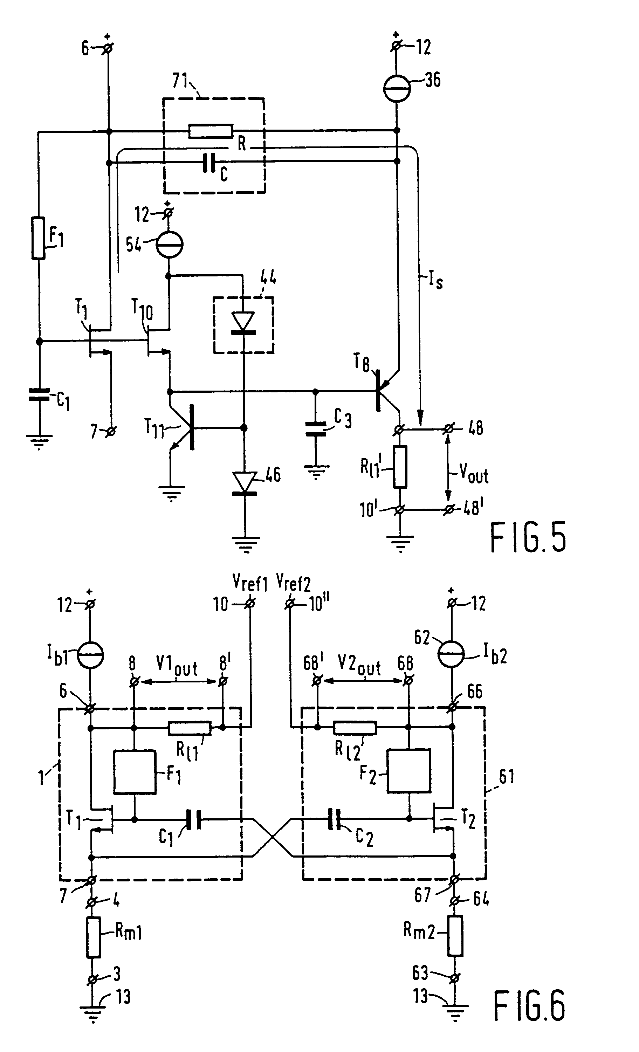

Figure 5 shows another embodiment of the amplifier circuit. The amplifier circuit of Figure 5 is a further elaboration of the circuit of Figure 3B. Also in this case cascoding can be applied.

The amplifier circuit of Figure 5 differs from the amplifier circuit of Figure 3B in that it further comprises an impedance network 71. Further, diode 46 and a capacitor element C₃ are present. An emitter terminal of the transistor T₈ is coupled to the first terminal 6 of the amplifier circuit via the impedance network 71, as well as to an output terminal of the current source 36. The collector terminal of the transistor T₈ is coupled to a terminal of the load impedance R₁₁'. From the Figure, it appears that the reference point 10 in Figure 3B has now become the reference point 10', which has the same potential as the first point 13 of constant potential, that is ground.

The base terminal of the transistor T₁₁ is coupled via the diode 46 to the point 13 of constant potential. The base terminal of the transistor T₈ is coupled to the first point 13 of constant potential via the capacitor element C₃.

Signal currents Iₛ generated by the MR element Rₘ₁ flow from the MR element Rₘ₁ to the terminal 7, via the transistor T₁, the impedance network 71 and the transistor T₈ to the load impedance R₁₁, the terminals 48,48' now forming the output terminal of the arrangement. The capacitor element C₃ filters out a noise component that would otherwise be present in the output signal at the output terminal 48,48'.

It should be noted that the embodiments of the Figures 3A, 3B, 4A and 4B, where the output 8,8' of the amplifier circuit is connected to the terminals of the load impedance R₁₁, are particularly suitable for use in an arrangement provided with only one MR element Rₘ₁. The embodiment of Figure 5, where the output of the amplifier circuit is formed by the terminals 48,48' is particularly useful in an arrangement having two MR elements Rₘ₁,Rₘ₂.

It should be further noted that likewise the circuits of the Figures 3A, 3B, 4A and 4B could have been provided with a load impedance R₁₁' coupled between the collector of the transistor T₈ and the point 13 of constant potential, which is preferred for an arrangement having two MR elements.

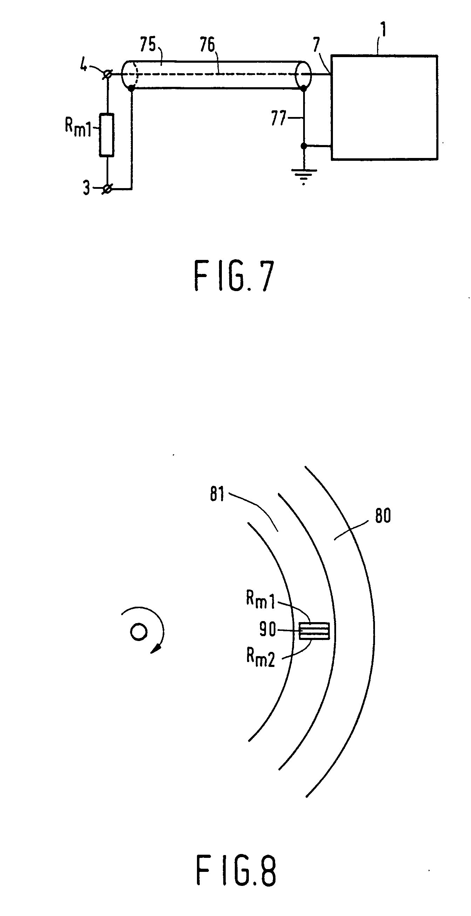

In such arrangements provided with two MR elements Rₘ₁ and Rₘ₂, see also the arrangement of Figure 6, each MR element is coupled to an amplifier circuit of a type as described above. The output of such an arrangement is then formed by the terminals 48 of each of the two amplifier circuits.

Figure 6 shows an embodiment of an arrangement which is in the form of a balanced circuit, and comprises two MR elements. The arrangement comprises a read head having a first and a second magneto-resistive element Rₘ₁ and Rₘ₂ respectively. Both MR elements Rₘ₁ and Rₘ₂ of the head scan the same track (not shown), so that they read the same signal from the track. The left hand part of the circuit shown in Figure 6 is largely identical to the circuit diagram shown in Figure 1. A first terminal 63 of the MR element Rₘ₂ is connected to the first point 13 of constant potential (ground). Further, a second bias-current generator 62 is available, having an output for supplying a second bias current (I_{b2}). Another terminal of the bias-current generator 62 is coupled to the terminal 12, on which the positive supply voltage is available. The amplifier circuit 61 has a first terminal 66 coupled to the output of the second bias-current generator 62 and a second terminal 67 coupled to the second terminal 64 of the second magneto-resistive element Rₘ₂. The second bias-current generator 62, the second amplifier circuit 61 and the second magneto-resistive element Rₘ₂ form a series arrangement between the terminals 12 and 13.

The second amplifier circuit 61 comprises a transistor T₂, which is in the form of a MOS transistor, a load impedance R₁₂, a feedback circuit F₂ and a capacitor element C₂. The source terminal of the transistor T₂ is coupled to the second terminal 67 of the amplifier circuit 61. The drain terminal of the transistor T₂ is coupled to the first terminal 66 of the amplifier circuit 61. The gate terminal of the transistor T₂ is coupled to the first terminal 66 of the amplifier circuit 61, via the feedback circuit F₂. Further, the gate terminal of the transistor T₂ is coupled to the source terminal of the transistor T₁ via the second capacitor element C₂. Moreover, the gate terminal of the transistor T₁ is coupled to the source terminal of the transistor T₂ via the capacitor element C₁. The cross-coupled connection of the capacitor elements, as shown in Figure 6, reduces the noise. A load impedance R₁₂ is coupled between the terminal 66 of the amplifier circuit 61 and a reference point 10", on which point a reference voltage V_{ref2} is available. The voltage V_{ref2} may differ from the voltage V_{ref1}, as the DC voltages across the MR elements Rₘ₁ and Rₘ₂ can be different owing to mismatch of the resistance of the MR elements and/or unequal MR bias currents I_{b1} and I_{b2}.

Constructions similar to the feedback circuits of the Figures 2A, 2B or 2C can be used for the feedback circuit F₂ of Figure 6. It will further be clear that the amplifier circuits as shown in the Figures 3A, 3B, 4A, 4B and 5 can be used for the amplifier circuit 61 of Figure 6.

It has been said previously that the two MR elements Rₘ₁,Rₘ₂ read a signal from the same track. When the two output signals V₁ₒᵤₜ and V₂ₒᵤₜ are added, an output signal which is the sum of both signals will appear, and systematic DC offset in both amplifier circuits 1 and 61 will cancel. This systematic DC offset is for example the term V_{ch1}-V_{ch2} between the nodes 6 and 10 (Figure 3A), discussed previously, or the DC voltage across the grounded load resistors, such as R₁₁' in Figure 5.

Figure 7 shows a further improvement of the arrangement having only one MR element. Figure 7 shows the provision of an electro-magnetic shielding 75 over the electrical connection 76 connecting the terminal 4 of the MR element Rₘ₁ with the terminal 7 of the amplifier circuit 1. The shielding 75 is connected to ground via the electrical connection 77. This shielding prevents electro-magnetic stray fields from disturbing the signals read out by means of the head. The shielding can be realized by means of a kind of coaxial cable. However, also simpler constructions can be used for the shielding means, for instance by wrapping the ground conductor around the signal carrying conductor.

Figure 8 shows a top view of the reading out of information from a track on the disk shaped record carrier 80, by means of a read head having two MR elements. Both MR elements Rₘ₁ and Rₘ₂ are coupled together via an insulating layer 90 and both read the full width of the same track 81.

The arrangements disclosed are preferably intended for hard disk applications, for low supply voltages, such as 3.3 V ± 10% and 5.0 V ± 10%. The bias current can be kept low, as the bias current is practically only needed for the MR element. A low-noise amplification of the signals read out can be obtained. The record carrier is preferably connected to ground via an electrical connection.

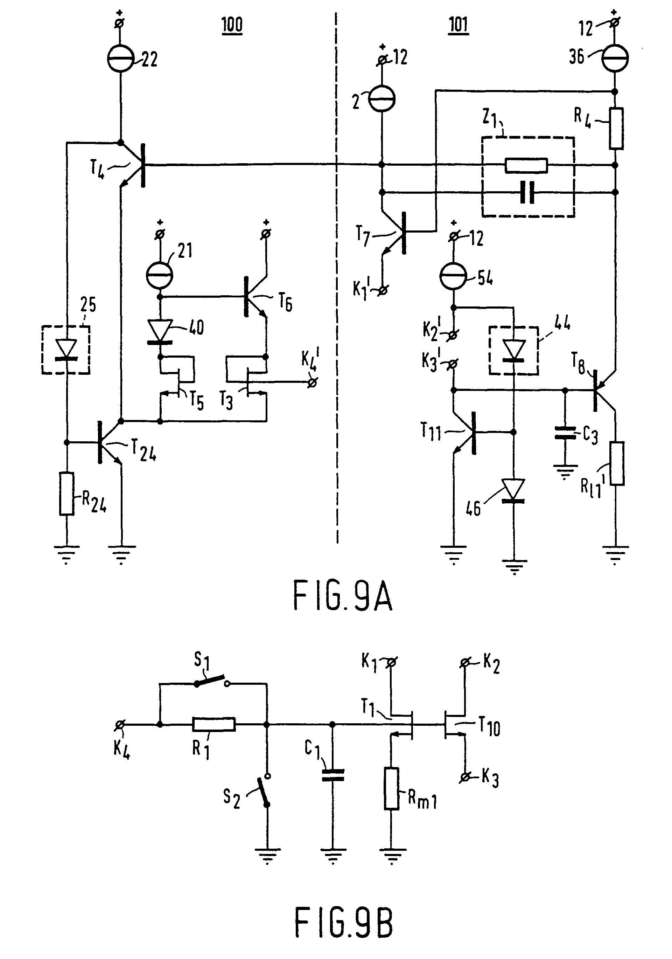

Figures 9A and 9B show units that can be coupled together in order to realize a multiplexed read out of information from a track on a record carrier by means of two or more MR elements. Figure 9A shows the circuit part which is common to all MR elements and Figure 9B shows the circuit part for each MR element. Only one such circuit part for the MR element Rₘ₁ is shown. For other MR elements the circuit part of Figure 9B should be copied. The common circuit part of Figure 9A shows at the left side of the vertical broken line a circuit part indicated by the reference numeral 100, which circuit part is largely resembles the feedback circuit of Figure 2C. It lacks the resistor R₁ and the switch S₁, which are included in the circuit part shown in Figure 9B. At the right hand side of the broken line, the circuit part 101 largely resembles the amplifier circuits of Figure 4A and 5.

Two or more of the circuits of Figure 9B can be coupled to the common circuit of Figure 9A by interconnecting the terminal k₁' of the common circuit of Figure 9A with the terminals k₁ of the two or more circuit parts of Figure 9B. In the same way the terminals k₂ and k₂', k₃ and k₃', and k₄ and k₄' are interconnected. Multiplexing is realized by means of the switches S₂ in each of the circuits of Figure 9B. One of the switches S₂ of one of the circuits of Figure 9B coupled to the common circuit of Figure 9A, is opened and the switches S₂ of the other circuits of Figure 9B are closed. In that situation, all of the MR elements Rₘ₁ are switched off except one, so that the signal read by that MR element is applied to and amplified by the circuit part of Figure 9A.

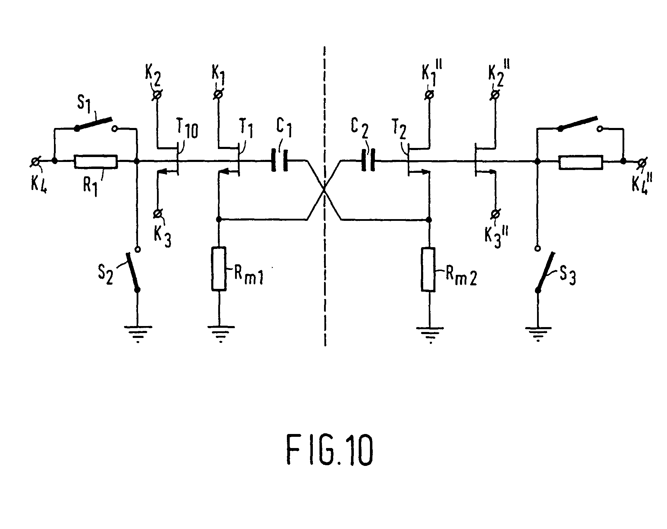

Figure 10 shows the circuit part of a balanced version of the head, comprising two MR elements Rₘ₁ and Rₘ₂, in a fashion as shown in Figure 6, where multiplexing is made possible. Figure 10 shows the circuit part including the two MR elements Rₘ₁, Rₘ₂ that is separate for each of the heads comprising two MR elements. The circuit part is largely mirror symmetrical, where the left hand part, left from the vertical broken line in Figure 10, is the same as the circuit part of Figure 9B. The circuit part of the transistors T₁ and T₂ and the capacitors C₁ and C₂ is identical to the corresponding circuit part of those elements in Figure 6.

The circuit part of Figure 9A is doubled, so as to obtain the common circuit part for each of the heads. The circuit part of Figure 9A is thus coupled to the left hand part of the circuit of Figure 10, as has been explained above for the interconnection between the circuits of Figure 9A and 9B. The right hand circuit part of Figure 10 is coupled to a circuit part identical to the circuit part of Figure 10A. Switching the head of Figure 10 into the circuit means that both switches S₂ and S₃ are in the open position as shown. Consequently, the corresponding switches S₂ and S₃ of the other heads coupled to the common circuit are in their closed position. Switching the head off is realized by closing both switches S₂ and S₃.

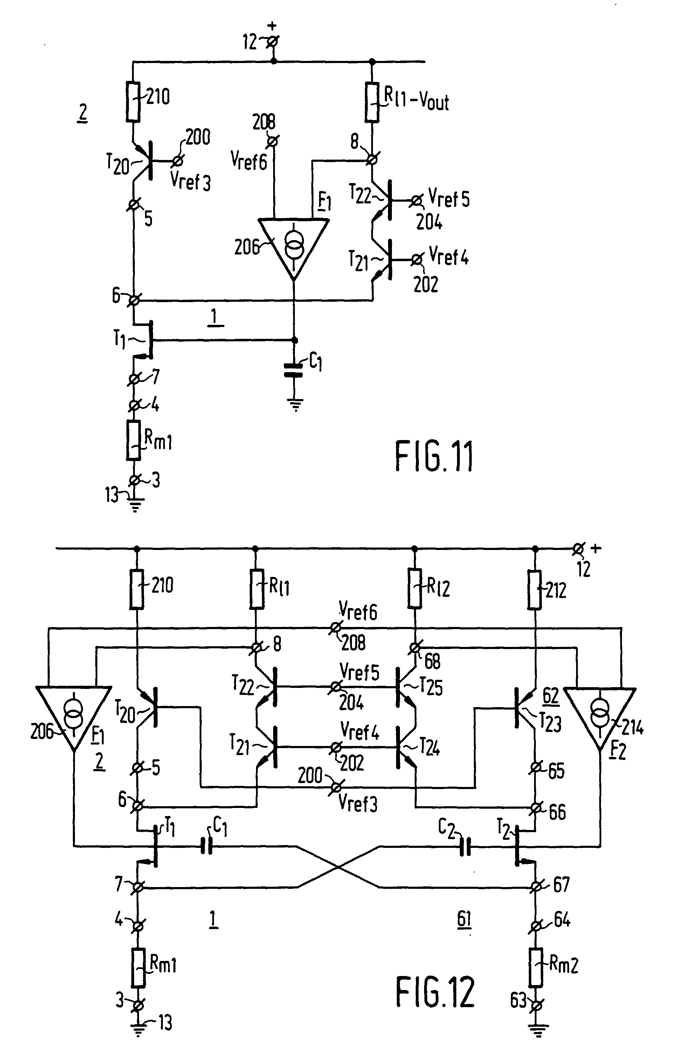

Figure 11 shows an alternative further-elaborated version of the amplifier circuit 1 of Figure 1. By way of example the bias current generator 2 is implemented with a PNP transistor T₂₀, having the emitter coupled to the point of constant positive potential 12 via degeneration resistor 210, the base connected to a reference point 200 which supplies a reference voltage V_{ref3} and the collector terminal to the output 5 of the bias current generator 2. The first terminal 6 of the amplifier circuit 1 is directly connected to the output 5.
However, in contradistinction to Figure 1, the terminal 8, which interconnects the load impedance R₁₁ and the feedback circuit F₁, is connected to the drain of the transistor T₁ via the collector-emitter path of a NPN transistor T₂₁. The emitter of transistor T₂₁ is connected to the drain of transistor T₁, the base is connected to a reference point 202 which supplies a reference voltage V_{ref4} and the collector is coupled to the load impedance R₁₁. The transistors T₁ and T₂₁ form a cascoded output stage. The collector of transistor T₂₁ may be connected to the load impedance R₁₁ via the collector-emitter path of an optional further NPN cascode transistor T₂₂, the base of which further transistor T₂₂ is connected to a reference point 204 which supplies a reference voltage V_{ref5}. The feedback circuit F₁ is a transconductance type stage 206 having differential voltage inputs connected to the terminal 8 and a reference point 208 which supplies a reference voltage V_{ref6} and having a high-ohmic current output coupled to the gate of transistor T₁. The transconductance Gm of the transconductance stage 206 should have a low value as it determines the cut-off frequency of the feedback circuit F₁.

Transistor T₂₀ and emitter resistor 210 can be implemented with a programmable current output digital to analog converter (IDAC) for supplying the bias current of the magneto-resistive (MR) element. In the arrangement of Figure 11 the IDAC supplies the variable part of the MR element's bias current, for instance 0 mA to 15.5 mA in steps of 0.5 mA, whereas a fixed current, for example 5 mA, is provided by the low-ohmic cascode output stage T₂₁. In order to obtain low noise, transistor T₁ should be large. The advantages of the arrangement of Figure 11 are: (1) the large low-noise MOS transistor T₁ and the IDAC can have a low output impedance, since they feed their respective currents into a very low-ohmic emitter of the cascode transistor T₂₁; (2) the drain-to-gate capacitance of the large transistor T₁ is not Millered; (3) the IDAC provide lower bias current and a corresponding lower noise; and (4) the IDAC feeds its current to a low voltage node, which permits the value of emitter resistor 210 to increase, resulting in a further reduction of noise. It is to be noted that the bias current generator 2 can be omitted entirely, if only the fixed bias current supplied by the cascode output stage T₂₁ is sufficient to bias the MR element.

Figure 12 shows a balanced version of the arrangement of Figure 11. The two amplifiers 1 and 61, in particular the capacitors C₁ and the corresponding capacitor C₂ of the second amplifier 61, are interconnected in a similar fashion as shown in Figure 6. The degeneration resistor 212, the PNP transistor T₂₃, the NPN transistor T₂₄, the NPN transistor T₂₅ and the transconductance stage 214 of the second amplifier 61 correspond with the degeneration resistor 210, the PNP transistor T₂₀, the NPN transistor T₂₁, the NPN transistor T₂₂ and the transconductance stage 206 of the first amplifier 1 and are connected similarly. At high frequencies the capacitors C₁ and C₂ form short circuits and place the gate-source paths of the transistors T₁ and T₂ anti-parallel. The same applies to the two individual equivalent noise resistors Rₙ of the MOS transistors T₁ and T₂. The noise resistance Rₙ is about equal to Rₒ, Rₒ being the inverse of the transconductance of the transistors T₁ and T₂. The total effective noise resistance in the first amplifier 1 of the arrangement of Figure 12 is Rₘ₁+Rₒ/2 instead of Rₘ₁+Rₒ of the first amplifier 1 of the arrangement of Figure 11. The balanced version thus provides a reduction of noise. One of the MR elements Rₘ₁ or Rₘ₂ may be omitted in single stripe MR read heads. In that case terminal 7 or 67 is coupled to ground 13.

In the embodiments as shown in the Figures, certain transistors, for example the transistors T₁, T₂, T₃, T₅ and T₁₀ are preferably unipolar MOS transistors; other transistors such as the transistors T₄, T₂₄, T₆, T₇, T₈, T₉, T₁₁ and T₂₁, are preferably bipolar transistors. It is, however, possible to use bipolar transistors instead of unipolar transistors and vice versa, or to use only bipolar or only unipolar transistors. The first main flow terminal, the second main flow terminal and the control terminal of a transistor correspond to, respectively, the source terminal, the drain terminal and gate terminal of an unipolar transistor and to, respectively, the emitter terminal, the collector terminal and base terminal of a bipolar transistor.

## Claims

1. Arrangement for reading out an information signal from a magnetic record carrier, comprising
- a read head having a first magneto-resistive element (Rₘ₁) with a first terminal (3) connected to a first point (13) of constant potential, and with a second terminal (4),
- a first bias-current means (2; T₂₀,T₂₁) for supplying a bias-current,
- a first amplifier circuit (1) comprising an output terminal (8) for supplying the information signal (Vₒᵤₜ), a first terminal (6) coupled to the first bias-current means (2; T₂₀,T₂₁) and to the output terminal (8), a second terminal (7) coupled to the second terminal (4) of the first magneto-resistive element (Rₘ₁) so as to form a series arrangement of the first bias-current means (2; T₂₀,T₂₁), the first amplifier circuit (1) and the magneto-resistive element (Rₘ₁) between a second point (12) of constant potential and said first point (13) of constant potential, the first amplifier circuit (1) further comprising a first transistor (T₁), a first feedback circuit (F₁), a first load impedance (R₁₁) and a first capacitor element (C₁), a first main flow terminal of the first transistor (T₁) being connected to the second terminal (7) of the first amplifier circuit (1), a second main flow terminal of the first transistor (T₁) being coupled to the first terminal (6) of the first amplifier circuit (1), a control terminal of the first transistor (T₁) being coupled to the output terminal (8) of the first amplifier circuit (1) via the first feedback circuit (F₁), the first load impedance (R₁₁) being coupled between the output terminal (8) of the first amplifier circuit (1) and a reference voltage terminal (12), **characterized in that** the arrangement further comprises
- a second bias-current means (62; T₂₃,T₂₄) for supplying a bias-current,
- a second amplifier circuit (61) comprising an output terminal (68), a first terminal (66) coupled to the second bias-current means (62; T₂₃,T₂₄) and to the output terminal (68), a second terminal (67) for coupling to a second terminal (64) of a second magneto-resistive element (Rₘ₂) of the read head for reading out the same information signal from the magnetic record carrier as the first magneto-resistive element (Rₘ₁) so as to form a series arrangement of the second bias-current means (62; T₂₃,T₂₄), the second amplifier circuit (61) and the second magneto-resistive element (Rₘ₂) between the second point (12) of constant potential and said first point (13) of constant potential, the second amplifier circuit (61) further comprising a second transistor (T₂), a second feedback circuit (F₂), a second load impedance (R₁₂) and a second capacitor element (C₂), a first main flow terminal of the second transistor (T₂) being connected to the second terminal (67) of the second amplifier circuit (61), a second main flow terminal of the second transistor (T₂) being coupled to the first terminal (66) of the second amplifier circuit (61), a control terminal of the second transistor (T₂) being coupled to the output terminal (68) of the second amplifier circuit (61) via the second feedback circuit (F₂), the second load impedance (R₁₂) being coupled between the output terminal (68) of the second amplifier circuit (61) and a reference voltage terminal (12), and **in that**
the control terminal of the second transistor (T₂) is coupled to the second terminal (7) of the first amplifier circuit (1) via the second capacitor element (C₂), and the control terminal of the first transistor (T₁) is coupled to the second terminal (67) of the second amplifier circuit (61) via the first capacitor element (C₁).

2. Arrangement as claimed in claim 1, **characterized in that** the first terminal (6) of the first amplifier circuit (1) is coupled to the output terminal (8) of the first amplifier circuit (1) via a cascode transistor (T₂₁) having a first main flow terminal connected to the first terminal (6) of the first amplifier circuit (1) and a second main flow terminal coupled to the output terminal (8) of the first amplifier circuit (1) and **in that** the first terminal (66) of the second amplifier circuit (61) is coupled to the output terminal (68) of the second amplifier circuit (61) via a cascode transistor (T₂₄) having a first main flow terminal connected to the first terminal (66) of the second amplifier circuit (61) and a second main flow terminal coupled to the output terminal (68) of the second amplifier circuit (61).

3. Arrangement as claimed in claim 2, **characterized in that** the second main flow terminal of the cascode transistor (T₂₁) of the first amplifier circuit (1) is coupled to the output terminal (8) of the first amplifier circuit (1) via a further cascode transistor (T₂₂) having a first main flow terminal connected to the second main flow terminal of said first mentioned cascode transistor (T₂₁) of the first amplifier circuit (1) and a second main flow terminal connected to the output terminal (8) of the first amplifier circuit (1) and **in that** the second main flow terminal of the cascode transistor (T₂₄) of the second amplifier circuit (61) is coupled to the output terminal (68) of the second amplifier circuit (61) via a further cascode transistor (T₂₅) having a first main flow terminal connected to the second main flow terminal of said first mentioned cascode transistor (T₂₄) of the second amplifier circuit (61) and a second main flow terminal connected to the output terminal (68) of the second amplifier circuit (61).

4. Arrangement as claimed in claim 1, 2 or 3, **characterized in that** the first feedback circuit (F₁) comprises a transconductance stage (206) having differential voltage inputs coupled to the output terminal (8) of the first amplifier circuit (1) and a reference voltage terminal (208) and a current output terminal coupled to the control terminal of the first transistor T₁ and **in that** the second feedback circuit F₂ comprises a transconductance stage (214) having differential voltage inputs coupled to the output terminal (68) of the second amplifier circuit (61) and the reference voltage terminal (208) and a current output terminal coupled to the control terminal of the second transistor T₂.

5. Arrangement as claimed in claim 1, 2, 3 or 4, **characterized in that** at least one of the first bias current means (2; T₂₀,T₂₁) and the second bias current means (62; T₂₃,T₂₄) comprises a bias-current generator (2;62) having an output (5; 65) connected to the first terminal (6) of the first amplifier circuit or to the first terminal (66) of the second amplifier circuit.

## Patentansprüche

1. Einrichtung zum Auslesen eines Informationssignals aus einem magnetischen Aufzeichnungsträger, wobei diese Einrichtung die nachfolgenden Elemente umfasst:
- einen Lesekopf mit einem ersten Magnetwiderstandselement (Rₘ₁), das eine erste Klemme (3) aufweist, die mit einem ersten Punkt (13) konstanten Potentials verbunden ist, sowie eine zweite Klemme (4),
- ein erstes Bias-Strommittel (2; T₂₀, T₂₁) zum Liefern eines Bias-Stromes,
- eine erste Verstärkerschaltung (1) mit einer Ausgangsklemme (8) zum Liefern des Informationssignals (Vₒᵤₜ), wobei eine erste Klemme (6) mit dem ersten Bias-Strommittel (2; T₂₀, T₂₁) sowie mit der Ausgangsklemme (8) gekoppelt ist, wobei eine zweite Klemme (7) mit der zweiten Klemme (4) des ersten Magnetwiderstandselementes (Rₘ₁) gekoppelt ist zum Bilden einer Reihenschaltung aus diesem ersten Bias-Strommittel (2; T₂₀, T₂₁), der ersten Verstärkerschaltung (1) und dem Magnetwiderstandselement (Rₘ₁) zwischen einem zweiten Punkt (12) konstanten Potentials und dem genannten ersten Punkt (13) konstanten Potentials, wobei die erste Verstärkerschaltung (1) weiterhin einen ersten Transistor (T₁), eine erste Rückkopplungsschaltung (F₁), eine erste Belastungsimpedanz (R₁₁) und ein erstes Kondensatorelement (C₁) aufweist, wobei eine erste Hauptstromklemme des ersten Transistors (T₁) mit der zweiten Klemme (7) der ersten Verstärkerschaltung (1) verbunden ist, wobei eine zweite Hauptstromklemme des ersten Transistors (T₁) mit der ersten Klemme (6) der ersten Verstärkerschaltung (1) gekoppelt ist, wobei eine Steuerklemme des ersten Transistors (T₁) über die erste Rückkopplungsschaltung (F₁) mit der Ausgangsklemme (8) der ersten Verstärkerschaltung (1) gekoppelt ist, wobei die erste Belastungsimpedanz (R₁₁) zwischen der Ausgangsklemme (8) der ersten Verstärkerschaltung (1) und einer Bezugsspannungsschaltung (12) gekoppelt ist, **dadurch gekennzeichnet, dass** die Einrichtung weiterhin die nachfolgenden Elemente umfasst:
- ein zweites Bias-Strommittel (62; T₂₃, T₂₄) zum Liefern eines Bias-Stromes,
- eine zweite Verstärkerschaltung (61) mit einer Ausgangsklemme (68), einer ersten Klemme (66), die mit dem zweiten Bias-Strommittel (62; T₂₃, T₂₄) sowie mit der Ausgangsklemme (68) gekoppelt ist, einer zweiten Klemme (67) zum Koppeln mit einer zweiten Klemme (64) eines zweiten Magnetwiderstandselementes (Rₘ₂) des Lesekopfes zum Auslesen desselben Informationssignals aus dem magnetischen Aufzeichnungsträger wie das erste Magnetwiderstandselement (Rₘ₁), zum Bilden einer Reihenschaltung aus dem zweiten Bias-Strommittel (62; T₂₃, T₂₄), der zweiten Verstärkerschaltung (61) und dem zweiten Magnetwiderstandselement (Rₘ₂) zwischen dem zweiten Punkt (12) konstanten Potentials und dem genannten ersten Punkt (13) konstanten Potentials, wobei die zweite Verstärkerschaltung (61) weiterhin einen zweiten Transistor (T₂), eine zweite Rückkopplungsschaltung (F₂), eine zweite Belastungsimpedanz (R₁₂) und ein zweites Kondensatorelement (C₂) umfasst, wobei eine erste Hauptstromklemme des zweiten Transistors (T₂) mit der zweiten Klemme (67) der zweiten Verstärkerschaltung (61) verbunden ist, wobei eine zweite Hauptstromklemme des zweiten Transistors (T₂) mit der ersten Klemme (66) der zweiten Verstärkerschaltung (61) gekoppelt ist, wobei eine Steuerklemme des zweiten Transistors (T₂) über die zweite Rückkopplungsschaltung (F₂) mit der Ausgangsklemme (68) der zweiten Verstärkerschaltung (61) gekoppelt ist, wobei die zweite Belastungsimpedanz (R₁₂) zwischen der Ausgangsklemme (68) der zweiten Verstärkerschaltung (61) und einer Bezugsspannungsklemme (12) gekoppelt ist, und dass die Steuerklemme des zweiten Transistors (T₂) über das zweite Kondensatorelement (C₂) mit der zweiten Klemme (7) der ersten Verstärkerschaltung (1) gekoppelt ist, und die Steuerklemme des ersten Transistors (T₁) über das erste Kondensatorelement (C₁) mit der zweiten Klemme (67) der zweiten Verstärkerschaltung (61) gekoppelt ist.

2. Einrichtung nach Anspruch 1, **dadurch gekennzeichnet, dass** die erste Klemme (6) der ersten Verstärkerschaltung (1) über einen Kaskodentransistor (T₂₁) mit der Ausgangsklemme (8) der ersten Verstärkerschaltung (1) gekoppelt ist, wobei von diesem Transistor eine erste Hauptstromklemme mit der ersten Klemme (6) der ersten Verstärkerschaltung (1) gekoppelt ist und wobei eine zweite Hauptstromklemme mit der Ausgangsklemme (8) der ersten Verstärkerschaltung (1) gekoppelt ist und dass die erste Klemme (66) der zweiten Verstärkerschaltung (61) über einen Kaskodentransistor (T₂₄) mit der Ausgangsklemme (68) der zweiten Verstärkerschaltung (61) gekoppelt ist, wobei von diesem Transistor eine erste Hauptstromklemme mit der ersten Klemme (66) der zweiten Verstärkerschaltung (61) verbunden ist und wobei eine zweite Hauptstromklemme mit der Ausgangsklemme (68) der zweiten Verstärkerschaltung (61) gekoppelt ist.

3. Einrichtung nach Anspruch 2, **dadurch gekennzeichnet, dass** die zweite Hauptstromklemme des Kaskodentransistors (T₂₁) der ersten Verstärkerschaltung (1) über einen weiteren Kaskodentransistor (T₂₂) mit der Ausgangsklemme (8) der ersten Verstärkerschaltung (1) gekoppelt ist, wobei eine erste Hauptstromklemme des Kaskodentransistors mit der zweiten Hauptstromklemme des genannten ersten Kaskodentransistors (T₂₁) der ersten Verstärkerschaltung (1) verbunden ist und weobei eine zweite Hauptstromklemme mit der Ausgangsklemme (8) der ersten Verstärkerschaltung (1) verbunden ist, und dass die zweite Hauptstromklemme des Kaskodentransistors (T₂₄) der zweiten Verstärkerschaltung (61) über einen weiteren Kaskodentransistor (T₂₅) mit der Ausgangsklemme (68) der zweiten Verstärkerschaltung (61) gekoppelt ist, wobei eine erste Hauptstromklemme des Kaskodentransistors mit der zweiten Hauptstromklemme des genannten erstgenannten Kaskodentransistors (T₂₄) der zweiten Verstärkerschaltung (61) verbunden ist und wobei eine zweite Hauptstromklemme mit der Ausgangsklemme (68) der zweiten Verstärkerschaltung (61) verbunden ist.

4. Einrichtung nach Anspruch 1, 2 oder 3, **dadurch gekennzeichnet, dass** die erste Rückkopplungsschaltung (F₁) eine Transkonduktanzstufe (206) aufweist, deren Differenzspannungseingänge mit der Ausgangsklemme (8) der ersten Verstärkerschaltung (1) und mit einer Bezugsspannungsklemme (208) verbunden sind und wobei eine Stromausgangsklemme mit der Steuerklemme des ersten Transistors T₁ gekoppelt ist und dass die zweite Rückkopplungsschaltung F₂ eine Transkonduktanzstufe (214) aufweist, deren Differenzspannungseingänge mit der Ausgangsklemme (68) der zweiten Verstärkerschaltung (61) und der Bezugsspannungsklemme (208) gekoppelt sind und wobei eine Stromausgangsklemme mit der Steuerklemme des zweiten Transistors T₂ gekoppelt ist.

5. Einrichtung nach Anspruch 1,2,3 oder 4, **dadurch gekennzeichnet, dass** wenigstens eines der ersten Bias-Strommittel (2; T₂₀,T₂₁) und die zweiten Bias-Spannungsmittel (62; T₂₃, T₂₄) einen Bias-Stromgenerator (2; 62) aufweist, dessen Ausgang (5; 65) mit der ersten Klemme (6) der ersten Verstärkerschaltung oder mit der ersten Klemme (66) der zweiten Verstärkerschaltung verbunden ist.

## Revendications

1. Dispositif pour la lecture d'un signal d'information à partir d'un porteur d'information magnétique, comprenant
- une tête de lecture présentant un premier élément magnéto-résistif ( R m 1) muni d'une première borne (3) connectée à un premier point (13) de potentiel constant et d'une deuxième borne (4),
- un premier moyen de courant d'établissement (2; T₂₀, T₂₁) pour fournir un courant d'établissement,
- un premier circuit amplificateur (1) comprenant une borne de sortie (8) pour fournir le signal d'information (Vₒᵤₜ), une première borne (6) couplée au premier moyen de courant de établissement (2; T₂₀, T₂₁) et à la borne de sortie (8), une deuxième borne (7) couplée à la deuxième borne (4) du premier élément magnéto-résistif (Rₘ₁) de façon à former un montage en série du premier élément de courant de établissement (2; T₂₀, T₂₁), du premier circuit amplificateur (1) et de l'élément magnéto-résistif (Rₘ₁) disposé entre un deuxième point de potentiel constant (12) et ledit premier point de potentiel constant (13), le premier circuit amplificateur (1) comprenant en outre un premier transistor (T₁) un premier circuit de couplage à réaction (F₁), une première impédance de charge (R₁₁) et un premier élément condensateur (C₁,) une première borne de flux principal du premier transistor (T₁) étant connectée à la deuxième borne du circuit amplificateur (1), une deuxième borne de flux principale du premier transistor (T₁) étant couplée à la première borne (6) du premier circuit amplificateur (1), une borne de commande du premier transistor (T₁) étant couplée à la borne de sortie (8) du premier circuit amplificateur (1) par l'intermédiaire du premier circuit de couplage à réaction (F₁), la première impédance de charge (R₁₁) étant couplée entre la borne de sortie du premier circuit amplificateur (1) et une borne de tension de référence(12),
**caractérisé en ce que** le dispositif comprend en outre,
- un deuxième moyen de courant d'établissement (62; T₂₃, T₂₄ ) pour fournir un courant d'établissement,
- un deuxième circuit amplificateur (61) comprenant une borne de sortie (68), une première borne (66) couplée au deuxième moyen de courant d'établissement (62; T₂₃, T₂₄ ) et à la borne de sortie (68), une deuxième borne (67) pour le couplage à une deuxième borne (64) d'un deuxième élément magnéto-résistif (Rₘ₂) de la tête de lecture pour la lecture du même signal d'information à partir du porteur d'information magnétique que le premier élément magnéto-résistif (Rₘ₁) de façon à former un montage en série du deuxième moyen de courant d'établissement (62; T₂₃, T₂₄), du deuxième circuit amplificateur (61) et du deuxième élément magnéto-résistif (Rₘ₂) disposé entre le deuxième point de potentiel constant (12) et ledit premier point de potentiel constant (13), le deuxième circuit amplificateur (61) comprenant en outre un deuxième transistor (T₂), un deuxième circuit de couplage à réaction (F₂), une deuxième impédance de charge (R₁₂) et un deuxième élément condensateur (C₂), une première borne de flux principale du deuxième transistor (T₂) étant connectée à la deuxième borne (67) du deuxième circuit amplificateur (61), une deuxième borne de flux principale du deuxième transistor (T₂) étant couplée à la première borne (66) du deuxième circuit amplificateur (61), une borne de commande du deuxième transistor (T₂) étant couplée à la borne de sortie (68) du deuxième circuit amplificateur (61) par l'intermédiaire du deuxième circuit de couplage à réaction (F₂), la deuxième impédance de charge (R₁₂) étant couplée entre la borne de sortie (68) du deuxième circuit amplificateur (61) et une borne de tension de référence (12), et **en ce que**
la borne de commande du deuxième transistor (T₂) est couplée à la deuxième borne (7) du premier circuit amplificateur (1) par l'intermédiaire du deuxième élément condensateur (C₂) et la borne de commande du premier transistor (T₁) est couplée à la deuxième borne (67) du deuxième circuit amplificateur (61) par l'intermédiaire du premier élément condensateur (C₁).

2. Dispositif selon la revendication 1, **caractérisé en ce que** la première borne (6) du premier circuit amplificateur (1) est couplée à la borne de sortie (8) du premier circuit amplificateur (1) par l'intermédiaire d'un transistor en cascode (T₂₁) présentant une première borne de flux principale connectée à la première borne (6) du premier circuit amplificateur (1) et une deuxième borne de flux principale couplée à la borne de sortie (8) du premier circuit amplificateur (1) et **en ce que** la première borne (66) du deuxième circuit amplificateur (61) est couplée à la borne de sortie (68) du deuxième circuit amplificateur (61) par l'intermédiaire d'un transistor en cascode (T₂₄) présentant une première borne de flux principale connectée à la première borne (66) du première circuit amplificateur (61) et une deuxième borne de flux principale couplée à la borne de sortie (68) du deuxième circuit amplificateur (61).

3. Dispositif selon la revendication 2, **caractérisé en ce que** le deuxième borne de flux principale du transistor en cascode (T₂₁) du premier circuit amplificateur (1) est couplée à la borne de sortie (8) du premier circuit amplificateur (1) par l'intermédiaire d'un autre transistor en cascode (T₂₂) présentant une première borne de flux principale connectée à la deuxième borne de flux principal du transistor en cascode mentionné ci-dessus en premier lieu (T₂₁) du premier circuit amplificateur (1) et une deuxième borne de flux principale connectée à la borne de sortie (8) du premier circuit amplificateur (1) et **en ce que** la deuxième borne de flux principale du transistor en cascode (T₂₄) de deuxième circuit amplificateur (61) est couplée à la borne de sortie (68) du deuxième circuit amplificateur (61) par l'intermédiaire d'un autre transistor en cascode (T₂₅) présentant une première borne de flux principale connectée à la deuxième borne de flux principale du transistor en cascode mentionné ci-dessus en premier lieu (T₂₄) du deuxième circuit amplificateur (61) et une deuxième borne de flux principale connectée à la borne de sortie (68) du deuxième circuit amplificateur (61).

4. Dispositif selon la revendication 1, 2 ou 3, **caractérisé en ce que** le premier circuit de couplage à réaction (F₁) comprend un étage de conductance de transfert (206) présentant des entrées de tension différentielles couplées à la borne de sortie (8) du premier circuit amplificateur (1) et une borne de tension de référence (208) et une borne de sortie de courant couplée à la borne de commande du premier transistor (T₁) et **en ce que** le deuxième circuit intégré de couplage à réaction (F₂) comprend un étage de conductance de transfert (214) présentant des entrées de tension différentielles couplées à la borne de sortie (68) du deuxième circuit amplificateur (61) et la borne de tension de référence (208) et une borne de sortie de courant couplée à la borne de commande du deuxième transistor (T₂).

5. Dispositif selon la revendication 1, 2, 3 ou 4, **caractérisé en ce qu'**au moins l'un du premier moyen de courant d'établissement (2; T₂₀,T₂₁) et du deuxième moyen de courant d'établissement (62; T₂₃, T₂₄) est muni d'un générateur de courant de établissement (2; 62) présentant une sortie (5; 65) connectée à la première borne (6) du premier circuit amplificateur ou à la première borne (66) du deuxième circuit amplificateur.
